# EUROPÄISCHE PATENTSCHRIFT

(11) **EP 4 251 559 B1**
(45) Veröffentlichungstag und Bekanntmachung des Hinweises auf die Patenterteilung: **25.02.2026**
(21) Anmeldenummer: 21806682.7
(22) Anmeldetag: 04.11.2021
(51) Int. Cl.: B81C 1/00

(54) **VERFAHREN ZUM VERSCHWEISSEN VON EINEM BAUTEIL**
METHOD FOR WELDING A COMPONENT
PROCÉDÉ DE SOUDAGE D'UN COMPOSANT

(30) Priorität: 25.11.2020 DE 102020214758
(43) Veröffentlichungstag der Anmeldung: 04.10.2023
(73) Patentinhaber: Robert Bosch GmbH, 70442 Stuttgart (DE)
(72) Erfinder: WAGNER, Stephan, 71299 Wimsheim (DE)
(86) Internationale Anmeldenummer: PCT/EP2021/080626
(87) Internationale Veröffentlichungsnummer: WO 2022/111969

(56) Entgegenhaltungen:
- DE-A1- 102017 125 140
- US-A1- 2009 205 371
- US-A1- 2015 313 016

## Beschreibung

Die Erfindung betrifft ein Verfahren zum Verschweißen von einem Bauteil umfassend mindestens einen ersten und/oder einen zweiten Bauelementabschnitt, wobei, insbesondere zwischen dem ersten und dem zweiten Bauelementabschnitt, eine Kaverne ausgebildet ist, wobei der erste und/oder der zweite Bauelementabschnitt eine Öffnung zur Druckverbindung der Kaverne mit einer Umgebung des Bauteils aufweist.

### Stand der Technik

Die Druckschrift DE 10 2014 210 857 A1 offenbart ein Bauteil und Verfahren, wobei die Drehratensensoren und Beschleunigungssensoren als zwei mikromechanische Strukturen nebeneinander ausgebildet sind. Zur gezielten Beeinflussung des Innendrucks innerhalb einer Kaverne zwischen zwei Bauelementen eines Bauteils wird ein Gettermaterial oder ein ausgasendes Material in einer zusätzlichen Kaverne zwischen den beiden Bauelementen angeordnet. Nach dem Bondprozess, in dem die beiden Bauelemente miteinander verbunden werden, soll diese zusätzliche Kaverne noch über eine Anschlussöffnung mit der Kaverne verbunden sein. Das Gettermaterial bzw. das ausgasende Material wird dann aktiviert, so dass Gase in der zusätzlichen Kaverne und der angeschlossenen Kaverne gebunden werden bzw. eine Ausgasung erfolgt. Erst wenn sich in der angeschlossenen Kaverne der angestrebte Innendruck eingestellt hat, wird die Anschlussöffnung zu der zusätzlichen Kaverne verschlossen. Auf diese Weise wird das Gettermaterial bzw. das ausgasende Material lediglich zur Einstellung eines definierten Innendrucks verwendet. Die Verwendung eines Gettermaterials erfordert jedoch eine zusätzliche Kaverne bzw. zusätzlichen Bauraum. DE 10 2017 125140 A1 offenbart ein Verfahren zum Herstellen eines hermetisch abgedichteten Gehäuses mit einem Halbleiterbauteil. Das Verfahren umfasst Einbringen eines Gehäuses mit einem Gehäusekörper und einem Gehäusedeckel in eine Prozesskammer, wobei der Gehäusedeckel einen Hohlraum des Gehäusekörpers abschließt und gasdicht an dem Gehäusekörper angebracht ist, wobei zumindest eine Öffnung in dem Gehäuse ausgebildet ist, und wobei zumindest ein Halbleiterbauteil in dem Hohlraum angeordnet ist. Das Verfahren umfasst weiter das Aufbringen von Dichtungsmaterial auf die zumindest eine Öffnung, während in der Prozesskammer eine vorbestimmte Gasatmosphäre herrscht. Glasfritte kann als Dichtungsmaterial verwendet werden, um die Öffnung abzudichten. Das nachfolgende Aufschmelzen des Dichtungsmaterials kann ein Bestrahlen des Dichtungsmaterials mit einem Laserstrahl umfassen.

### Offenbarung der Erfindung

Es wird ein Verfahren zum Verschweißen von einem Bauteil mit den Merkmalen des Anspruch 1 vorgeschlagen. Bevorzugte, vorteilhafte und/oder weitere Ausführungsformen der Erfindung ergeben sich aus den Unteransprüche, der nachfolgenden Beschreibung und/oder den Figuren.

Vorgeschlagen wird ein Verfahren zum Verschweißen von einem Bauteil, insbesondere von einem Bauteil mit einem mikroelektromechanischen System (einem sog. MEMS-Bauteil). Das zu verschweißende Bauteil ist vorzugsweise als ein Drehratensensor, ein Drucksensor oder ein Beschleunigungssensor ausgebildet und/oder weist diese auf. Das Bauteil ist in Schichtbauweise ausgebildet. Das Bauteil weist mindestens einen ersten und/oder einen zweiten Bauelementabschnitt auf, welche den Schichtaufbau des Bauteils bilden. Der erste und/oder der zweite Bauelementabschnitt ist vorzugsweise als ein Halbleiterbauelement und/oder als eine Halbleiterschicht (Substrat-Schicht) ausgebildet. Beispielsweise sind die Bauelementabschnitte jeweils auf einem Wafer ausgebildet, wobei mehrere erste und mehrere zweite Bauelementabschnitte auf dem jeweiligen Wafer nebeneinander angeordnet sind.

Der erste und/oder der zweite Bauelementabschnitt weist vorzugsweise eine mikroelektromechanische Struktur auf. Die mikroelektromechanische Struktur ist vorzugsweise als ein mikroelektronischer Schaltkreis, Aktuator oder Sensor ausgebildet. Beispielsweise bildet die mikroelektromechanische Struktur den Drehratensensor oder den Beschleunigungssensor und/oder ist eine Komponente dieser.

Das Bauteil weist mindestens eine Kaverne auf, welche insbesondere zwischen dem ersten und dem zweiten Bauelementabschnitt ausgebildet ist. Die Kaverne bildet eine Aushöhlung innerhalb des Bauteils, wobei die Kaverne vorzugsweise eine beliebige Form aufweist. Die Kaverne ist vorzugsweise geeignet, die mikroelektromechanische Struktur des ersten und/oder des zweiten Bauelementabschnitts aufzunehmen. Die Kaverne wird vorzugsweise beim Fügen des ersten und zweiten Bauelementabschnitts miteinander hergestellt, wobei der erste und der zweite Bauelementabschnitt vorzugsweise in einem Bondverfahren miteinander verbunden werden. Beispielsweise ist einer der Bauelementabschnitte als ein Cap-Wafer und der andere Bauelementabschnitt als ein MEMS-Wafer ausgebildet, wobei der Cap-Wafer mit dem MEMS-Wafer in dem Bondverfahren, z.B. Waferbondverfahren, zur Verkapselung miteinander verbunden werden, sodass die Kaverne im Inneren des Bauteils ausgebildet wird. Die mikroelektromechanische Struktur des MEMS-Wafer und/oder des Cap-Wafers wird in den Bondverfahren in der Kaverne eingekapselt. Dadurch ist es möglich, die für den Betreib der jeweiligen mikroelektromechanischen Struktur, z.B. Sensorstruktur, nötigen Kavitäten herzustellen. Beispielsweise wird ein bestimmter Innendruck, z.B. ein Unterdruck, in der Kaverne für die Sensorstruktur angelegt, um die Dämpfung der Sensorstruktur möglichst gering zu halten. Beispielsweise wird für einen Drehratensensor ein möglichst geringer Innendruck eingestellt, vorzugsweise ein Innendruck von weniger als 50 mbar und/oder mindestens 1 mbar. Hingegen ist vorzugsweise bei einem Beschleunigungssensor ein höherer Innendruck vorgesehen, welcher vorzugsweise weniger als 800 mbar und/oder mindestens 500 mbar aufweist.

Ferner ist vorgesehen, dass der erste und/oder der zweite Bauelementabschnitt eine Öffnung zur Druckverbindung der Kaverne mit einer Umgebung des Bauteils aufweist. Die Öffnung in einem der Bauelementabschnitte ist vorzugsweise als eine abgerundete Öffnung, z.B. Bohrung, ausgebildet, wobei die Öffnung vorzugsweise senkrecht zu dem Schichtaufbau des Bauteils in einer der Bauelementabschnitte eingebracht ist. Alternativ weist die Öffnung eine beliebige Grundform, z.B. Spalte oder Schlitz, auf, wobei die Öffnung vorzugsweise an einer Kontaktstelle der beiden Bauelementabschnitte, z.B. an einer Bondstelle, angeordnet ist.

Die Öffnung ist mit der Kaverne verbunden, insbesondere fluid- und/oder drucktechnisch verbunden, sodass insbesondere der in der Umgebung des Bauteils herrschende Druck und/oder Atmosphäre in der Kaverne eingestellt ist. Die Einstellung der Kavernenbedingungen durch die Umgebungsbedingungen des Bauteils erfolgt vorzugsweise vor dem Verfahren zum Verschweißen des Bauteils und/oder ist vorzugsweise als ein vorausgehender Schritt des Verfahrens ausgebildet. Das Verfahren ist zum Verschließen der Öffnung in dem ersten und/oder zweiten Bauelementabschnitt ausgebildet.

Bei dem Verfahren zum Verschweißen des Bauteils, insbesondere MEMS-Bauteil, wird ein Füllstück aus einem Füllmaterial an dem jeweiligen Bauelementabschnitt mit der Öffnung angeordnet, sodass die Öffnung durch das Füllstück zumindest abgedeckt und/oder ausfüllt wird.

Das Füllstück ist vorzugsweise in seiner Grundform an die Öffnung angepasst, sodass das Füllstück geeignet ist, die Öffnung zu überlappen und/oder die Öffnung zu verschließen. Beispielsweise ist das Füllstück in seiner Grundform als ein Zylinder, ein Konus, eine Kugel oder als eine Ronde ausgebildet. Alternativ ist das Füllstück formlos ausgebildet, wobei das Füllstück beispielsweise als ein Pulver oder eine Paste ausgebildet ist. Das Füllstück wird vorzugsweise in einem Applikationsschritt an dem Bauelementabschnitt mit der Öffnung angeordnet, wobei das Füllstück vorzugsweise temporär an dem jeweiligen Bauelementabschnitt befestigt wird. Vorzugsweise wird bei dem Applikationsschritt das Füllstück mit dem entsprechenden Bauelementabschnitt verbunden, insbesondere formschlüssig verbunden, sodass das Füllstück innerhalb der Öffnung gehalten wird. Alternativ oder optional ergänzend wird bei dem Applikationsschritt das Füllstück an den Bauelementabschnitt angeordnet, sodass die Öffnung und/oder ein Öffnungszugangsbereich der Öffnung abgedeckt wird. Vorzugsweise wird das Füllstück durch Adhäsion an dem Bauelementabschnitt gehalten. Beispielsweise haftet das Füllstück mit einer Kontaktfläche an einer Bauelementoberfläche des Bauelementabschnitts, welche um die Öffnung ausgebildet ist. Dieser alternative Applikationsschritt ist vorzugsweise vorgesehen, wenn das Füllstück als eine Ronde oder als ein Layer im Schichtaufbau des Bauteils ausgebildet ist. Vorzugsweise wird das Füllstück derart an dem Bauelementabschnitt angeordnet, dass zumindest ein Teilabschnitt des Füllstück außerhalb der Öffnung angeordnet wird. Beispielsweise ragt der Teilabschnitt des Füllstücks über die Bauelementoberfläche hinaus.

Nachfolgend sieht das Verfahren zum Verschweißen des Bauteils vor, dass das Füllstück mit dem jeweiligen Bauelementabschnitt durch ein Laserschweißverfahren verschweißt wird, sodass die Öffnung in dem Bauelementabschnitt durch das Füllmaterial des Füllstücks zum hermetischen Abdichten der Kaverne verschlossen wird.

In dem Laserschweißverfahren und/oder dem Schritt zum Laserschweißen wird zumindest das Füllstück thermisch, insbesondere durch einen Laserstrahl, behandelt, sodass das Füllmaterial des Füllstücks zumindest teilweise aufgeschmolzen wird. Vorzugsweise erhitzt der Laserstrahl das Füllstück mindestens bis zu einer Schmelztemperatur des Füllmaterials. In einer Variante außerhalb der beanspruchten Erfindung weist das Füllmaterial eine niedrigere Schmelztemperatur als ein Material der Bauelementabschnitte auf, sodass beim Verschweißen lediglich das Füllstück aufgeschmolzen wird. Dadurch wird ein Abtragen von Material des Bauelementabschnitts verhindert. Erfindungsgemäß weisen beide eine gemeinsame Schmelztemperatur auf, sodass diese beide aufgeschmolzen werden.

In diesem Verfahrensschritt wird die Kaverne hermetisch von der Umgebung des Bauteils abgedichtet. Die in der Kaverne herrschenden Bedingungen werden somit konstant aufrechtgehalten. Vorteilhaft ist, dass das Füllmaterial beim Verschweißen des Bauelementabschnitt mit dem Füllstück als ein Schweißzusatz fungiert, sodass ein geringes Volumen des Bauelementabschnitts aufgeschmolzen werden muss. Durch den Schweißzusatz wird beim Abkühlen der Schmelze und/oder des Schmelzbades Eigenspannungen reduziert, sodass Mikrorisse an der Schweißstelle verhindert werden. Dies führt zu einer besonders hohen Dichtigkeit der Schweißstelle. Durch das vorteilhafte Verfahren zum Verschweißen von dem Bauteil wird eine Ausfallrate der Bauteile durch undichte Kavernen reduziert. Durch das zusätzliche Füllmaterial des Füllstücks muss ein kleineres Materialvolumen oder nahezu kein Material des Bauteils aufgeschmolzen werden, um die Öffnung zu schließen. Dies schützt zudem das Bauteil beziehungsweise den Bauelementabschnitt vor Beschädigungen durch Abtragen von Material und/oder vor einer zu hohen thermischen Belastung beim Laserverschweißen.

Erfindungsgemäß ist vorgesehen, dass das Füllstück, das mit dem ersten oder dem zweiten Bauelementabschnitt verschweißt wird, aus einem zu dem jeweiligen Bauelementabschnitt artgleichen Füllmaterial hergestellt wird. Erfindungsgemäß bestehen der erste Bauelementabschnitt und/oder der zweite Bauelementabschnitt und das Füllstück aus Silizium oder einem siliziumhaltigen Halbleitermaterial. Besonders bevorzugt sind der erste oder der zweite Bauelementabschnitt und das Füllstück aus einem gemeinsamen Material hergestellt. Dies hat den Vorteil, dass die Materialien beim Verschweißen sich ausreichend fest miteinander verbinden und Eigenspannungen des Schmelzbades beim Abkühlen verringert werden. Erfindungsgemäß weisen die artgleichen Materialien eine gemeinsame Schmelztemperatur auf, z.B. Schmelztemperatur von Silizium (1410 °C), sodass im Laserschweißverfahren eine gleichmäßige Schweißstelle und/oder Schweißnaht in einem Übergangsbereich zwischen Bauelementabschnitt und Füllstück hergestellt wird.

In einer bevorzugten Ausgestaltung des Verfahrens ist vorgesehen, dass die Kaverne eine Gasfüllung aufweist, wobei die Kaverne über die Öffnung in einem der Bauelementabschnitte mit der Gasfüllung befüllt wird, wobei das Füllstück mit dem jeweiligen Bauelementabschnitt zur gasdichten Versiegelung der Kaverne verschweißt wird. Die Gasfüllung in der Kaverne wird vorzugsweise durch Fluten der Umgebung des Bauteils mit einem Gas erzeugt, wobei durch einen Druckausgleich das Gas aus der Umgebung des Bauteils über die Öffnung in die Kaverne strömt. Dieser Verfahrensschritt zum Begasen der Kaverne wird vorzugsweise vor dem Anordnen des Füllstücks an dem Bauelementabschnitt mit der Öffnung durchgeführt, sodass nachdem die Kaverne mit der Gasfüllung befüllt wird, das Füllstück an dem entsprechenden Bauelementabschnitt angeordnet wird, wobei diese anschließend durch Laserschweißen zur gasdichten Versiegelung der Kaverne verschweißt werden. Vorteilhaft ist, dass durch die Gasfüllung die für einen Sensorbetreib, z.B. Drucksensor, nötigen Kavernenbedingungen geschaffen werden können, wobei durch die Befüllung über die Öffnung sichergestellt ist, dass jedes Bauteil, z.B. jedes Bauteil einer Wafer-Anordnung, mit der gleichen Gasmenge befüllt ist. Das vorteilhafte Verfahren zum Verschweißen des Bauteils stellt zudem sicher, dass die Gasfüllung nicht über die Öffnung bzw. Schweißstelle entweichen kann, da durch das Füllmaterial des Füllstücks ein besonders materialstarker "Verschluss" für die Öffnung hergestellt wird.

In einer weiteren bevorzugten Ausgestaltung des Verfahrens ist vorgesehen, dass die Kaverne einen bestimmten Innendruck aufweist, wobei der bestimmte Innendruck in der Kaverne über die Öffnung in einem der Bauelementabschnitte angelegt wird, wobei das Füllstück mit dem jeweiligen Bauelementabschnitt zur druckdichten Versiegelung der Kaverne verschweißt wird. Vorzugsweise weist die Kaverne einen Unterdruck auf, wobei insbesondere ein Druck von weniger als 500 mbar, bevorzugt von weniger als 300 mbar, im Speziellen von weniger als 100 mbar, in der Kaverne ausgebildet ist. Der bestimmte Innendruck wird vorzugsweise in Abhängigkeit der mikroelektromechanischen Struktur bzw. der jeweiligen Sensorstruktur aufgebaut. Beispielsweise wird um eine Dämpfung der Sensorstruktur (Drehratensensor) möglichst gering zu halten, ein möglichst geringer Innendruck, z.B. 1 mbar, eingestellt. Dadurch kann der Drehratensensor mit einer relativ geringen Anregungsspannung betrieben werden. Im Unterscheid wird ein wesentlich höherer Innendruck, z.B. 500 mbar bei Sensorstrukturen, z.B. Beschleunigungssensoren, angelegt, um diese nicht zu Schwingungen anzuregen. Vorzugsweise wird dieser Verfahrensschritt vor dem Anordnen des Füllstücks an dem dementsprechenden Bauelementabschnitt ausgeführt. Vorteilhaft ist, dass das Füllstück als Schweißzusatz die Öffnung zuverlässig druckdicht verschließt, sodass eine ausreichende Stabilität der Schweißstelle hergestellt wird. Grundsätzlich werden derartige Öffnungen mit umliegendem aufgeschmolzenem Material des Bauelements verschlossen, welches in die Öffnung fließt. Beim Aushärten der Schmelze zieht diese sich innerhalb des Öffnungsbereiches muldenartig zurück, sodass eine Schweißstelle mit unbekannter Materialstärke entsteht. Folglich kommt es zu einer hohen Ausfallquote, da die Schweißstellen unterschiedlich druckdicht sind. Durch das Füllstück wird eine festlegbare Materialmenge beim Schweißen verwendet, welche eine gleichbleibende Materialstärke der Schweißstelle sicherstellt. Zudem ist vorteilhaft, dass durch die Geometrie des Füllstücks, z.B. als "Stöpsel" oder "Korken", eine erhöhte Dichtigkeit der Öffnung/Schweißstelle, insbesondere bei einem Unterdruck in der Kaverne, erzeugt wird.

Bei einer bevorzugten Ausgestaltung des Verfahrens ist vorgesehen, dass der erste und/oder der zweite Bauelementabschnitt eine Schweißverbindung zur Verbindung mit dem Füllstück aufweist, wobei die Schweißverbindung durch das Laserschweißverfahren hergestellt wird. Die Schweißverbindung ist insbesondere als eine stoffschlüssige Verbindung ausgebildet. Die Schweißverbindung zwischen einem der Bauelementabschnitte und dem Füllstück ist geeignet, das Füllstück, z.B. als Ronde oder Layer, an dem jeweiligen Bauelementabschnitt zu befestigen. Beispielsweise werden diese in einem ersten Teilschritt des Laserschweißverfahren temporär miteinander verbunden, sodass anschließend in einem zweiten Teilschritt des Laserschweißverfahrens die Öffnung verschweißt und/oder versiegelt wird.

Bei einer bevorzugten Konkretisierung des Verfahrens ist vorgesehen, dass in dem Laserschweißverfahren zumindest das Füllmaterial des Füllstücks durch einen Laserstrahl aufgeschmolzen wird, um die Schweißverbindung zwischen dem ersten und/oder dem zweiten Bauelementabschnitt mit dem Füllstück zu erzeugen. Insbesondere wird die Schweißverbindung durch Aufschmelzen von einem Teilabschnitt des Füllstücks erzeugt, wobei vorzugsweise der Teilabschnitt in einem angeordneten Zustand des Füllstücks überstehend zur Öffnung angeordnet wird. Beispielsweise steht das Füllstück mindestens 0,1 mm über die Öffnung hinaus und/oder ragt von der Öffnung ausgehend auf die umliegende Bauelementoberfläche. Insbesondere das Teilstück beziehungsweise ein Überstand des Füllstücks wird beim Laserschweißen durch den Laserstrahl aufgeschmolzen und mit seiner Umgebung verschweißt. In diesem Kontext ist das Füllstück als ein Verschlusselement zu verstehen, welches mit dem Bauelementabschnitt verschweißt wird. Folglich kann das Füllstück weitere Funktionen für das Bauteil aufweisen. Beispielsweise wird ein oder mehrere Bonddrähte zur elektrischen Verbindung des Bauteils durch das Füllstück gehalten und/oder an der Bauelementoberfläche fixiert. Alternativ oder optional ergänzend ist ein Bonddraht in dem Füllstück eingebettet, sodass dieser über die Schweißstelle in das Bauteil geführt wird.

Bei einer alternativen Ausgestaltung des Verfahrens ist vorgesehen, dass in dem Laserschweißverfahren zumindest das Füllmaterial des Füllstücks durch einen Laserstrahl vollständig aufgeschmolzen wird, um ein Schmelzbad aus zumindest dem Füllmaterial des Füllstücks zum Verschließen der Öffnung zu erzeugen. Das Füllmaterial des Füllstücks ist somit als ein Schweißzusatz ausgebildet, welcher vollständig aufgeschmolzen wird. Vorteilhaft an dem vollständigen Aufschmelzen des Füllstücks ist, dass das Schmelzbad sich in der Öffnung verteilt, sodass die Öffnung lückenlos geschlossen wird. Dadurch werden Passungsfehler durch Toleranzen bei der Fertigung und/oder Abweichungen der Geometrie des Füllstücks zur Öffnung vermieden und/oder behoben.

In einer weiteren Ausgestaltung des Verfahrens ist vorgesehen, dass das Bauteil ein mikroelektromechanisches System-Bauteil (MEMS-Bauteil), im Speziellen ein SI-MEMS-Bauteil, bildet, wobei der erste und/oder der zweite Bauelementabschnitt eine mikroelektromechanische Struktur aufweist, wobei die mikroelektromechanische Struktur innerhalb der Kaverne angeordnet wird.

Bei dem Verfahren zum Verschweißen des MEMS-Bauteils wird, wie zuvor beschrieben, das Füllstück aus einem Füllmaterial, insbesondere siliziumhaltiges Füllmaterial, an dem jeweiligen Bauelementabschnitt mit der Öffnung angeordnet, sodass die Öffnung durch das Füllstück zumindest abdeckt und/oder ausfüllt wird, wobei das Füllstück mit dem jeweiligen Bauelementabschnitt zur hermetischen Abdichtung der mikroelektromechanischen Struktur innerhalb der Kaverne durch das Laserschweißverfahren verschweißt wird.

Weitere Merkmale, Vorteile und Wirkungen der Erfindung ergeben sich aus der nachfolgenden Beschreibung bevorzugter Ausführungsbeispiele der Erfindung. Dabei zeigen:
Figur 1 eine Schnittdarstellung eines Bauteils mit einem ersten und einem zweiten Bauelementabschnitt mit einer Öffnung und mit einem Füllstück zur Anordnung an der Öffnung als ein bevorzugtes Ausführungsbeispiel eines Verfahrensschritts;
Figur 2 eine Detaildarstellung der Öffnung in dem ersten oder dem zweiten Bauelementabschnitt mit einem laserverschweißten Füllstück als ein bevorzugtes Ausführungsbeispiel eines weiteren Verfahrensschritts.

Ein Anwendungsbeispiel für die durch das nachfolgend beschriebene Verfahren hergestellten Bauteile sind sogenannte MEMS-Bauteile (microelectromechanical system-Bauteile). Die MEMS-Bauteile weisen mikroskopisch kleine elektromechanische Strukturen auf, welche mikroelektronische Schaltkreise, Aktuatoren oder Sensoren bilden. Beispielsweise sind die elektromechanischen Sensoren als Drehratensensoren oder als Beschleunigungssensoren ausgebildet.

Die elektromechanische Struktur ist im Schichtaufbau des MEMS-Bauteils ausgebildet. Diese werden mit Hilfe eines Bauelements verkappt, um die Sensorstrukturen zu schützen und einen definierten Druck für den jeweiligen Sensorbetrieb zu gewährleisten. Dazu ist eine Kaverne im Inneren des MEMS-Bauteil ausgebildet, welche die Sensorstrukturen aufnimmt und in welcher der definierte Druck herrscht. Die meist mit Unterdruck betreiben MEMS-Sensoren sind daher hermetisch dicht abgeschlossen. Um einen zuverlässigen Sensorbetrieb über die gesamte Lebensdauer des MEMS-Bauteil sicher zu stellen, ist es erforderlich den Druck in der Kaverne aufrecht zu erhalten. Vorzugsweise wird ein Loch in das Bauteil eingebracht, welches die innere Kaverne mit einer Umgebung des Bauteils verbindet. Über das Loch ist es möglich den Druck in der Kaverne über einen Umgebungsdruck des Bauteils zu bestimmen oder die Kaverne mit einem Gas zu fluten.

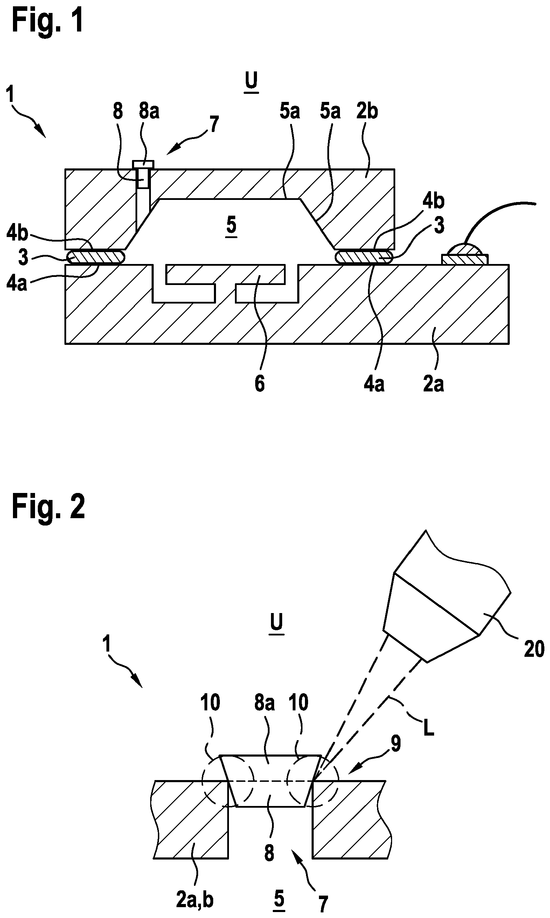

In der Figur 1 ist in einer Schnittdarstellung ein Bauteil 1 mit einem Schichtaufbau gezeigt. Das Bauteil 1 weist eine Abmessung von wenigen Millimetern auf, beispielsweise weist das Bauteil 1 eine Grundfläche von mindestens 2 mm² und eine Schichtaufbaustärke von mindestens 0,5 mm auf. Das Bauteil 1 ist als ein MEMS-Bauteil (micro-electro-mechanical system) ausgebildet. Das Bauteil 1 weist einen ersten und einen zweiten Bauelementabschnitt 2a, b auf, welche den Schichtaufbau des Bauteils 1 bilden. Die Bauelementabschnitte 2a, b sind beispielsweise in einem Herstellungsverfahren auf einem siliziumhaltigen Wafer ausgebildet, wobei mehrere Wafer-Level-Ebenen übereinander angeordnet und in einem Bondprozess miteinander verbunden werden. Die übereinander geschichteten Bauelementabschnitte 2a, b liegen mit Innenflächen 4a, b aneinander an, wobei ein Bondrahmen 3 die Innenflächen 4a, b miteinander verbindet. Der Bondrahmen 3 wird beispielsweise in dem Bondprozess bei der Herstellung des Bauteils 1 zwischen die Bauelementschnitte 2a, b aufgebraucht. Der zweite Bauelementabschnitt 2b ist als ein Kappenbauelement und/oder als eine sog. Cap oder Cap-Wafer ausgebildet, wobei der zweite Bauelementabschnitt 2b eine Kappenausnehmung 5a aufweist, welche als eine Aussparung und/oder Ausbuchtung in das Material des zweiten Bauelementabschnitts 2b eingebracht wird. Der erste Bauelementabschnitt 2a weist eine mikroelektromechanische Struktur 6 auf, welche auf einer Innenseite des ersten Bauelementabschnitts 2a ausgebildet ist. Die mikroelektromechanische Struktur 6 bilden beispielsweise eine mikroelektromechanische Komponente eines Sensors, Aktors, Schaltkreises, Oszillators und sind in Abhängigkeit dessen Betriebs ausgebildet. Diese können einen beliebigen Aufbau und unterschiedliche Strukturierungen aufweisen. Daher ist die mikroelektromechanische Struktur 6 in der Figur 1 lediglich stark schematisiert dargestellt.

Die beiden Bauelementabschnitte 2a, b werden so übereinander angeordnet, dass die Kappenausnehmung 5a des zweiten Bauelementabschnitts 2b der mikroelektromechanische Struktur 6 des ersten Bauelementabschnitts 2a zugewandt ist, sodass eine Kaverne 5 (ein Hohlraum) für die mikroelektromechanische Struktur 6 gebildet wird. Der Bondrahmen 3 ist umlaufend um die Kaverne 5 ausgebildet, wobei der Bondrahmen 3 grundsätzlich dazu geeignet ist, die beiden Bauelementabschnitte 2a, b zu verbinden und die Kaverne 5 hermetisch abzudichten.

Der zweite Bauelementabschnitt 2b beziehungsweise das Kappenbauelement wird grundsätzlich zum Schutz der mikroelektromechanischen Struktur 6 auf den ersten Bauelementabschnitt 2a aufgesetzt, wobei die Kaverne 5 zur Einstellung von Betriebsbedingungen der mikroelektromechanische Struktur 6 ausgebildet wird. Beispielsweise wird in der Kaverne 5 ein bestimmter Innendruck für den Betrieb der mikroelektromechanischen Struktur 6, z.B. Sensorstruktur, erzeugt. Alternativ oder optional ergänzend wird die Kaverne 5 mit einer Gasfüllung befüllt, welche die mikroelektromechanische Struktur 6 umgibt. Grundsätzlich kann der Druck oder die Gasfüllung durch ein Gettermaterial beziehungsweise durch ein ausgasendes Material erzeugt werden. Jedoch besteht die Gefahr, dass das Gettermaterial unterschiedliche Drücke in den Bauteilen erzeugt, sodass unterschiedliche Bedingungen für die mikroelektromechanische Struktur 6 vorliegen, welche z.B. zu Messfehlern bei einem der MEMS-Sensoren führt. Zudem benötigen diese Materialien zusätzlichen Bauraum, wodurch das Bauteil in seinen Abmessungen zunimmt und die Herstellungskosten, z.B. durch weniger Bauelementabschnitte auf einem "teuren" Wafer, steigen.

Um die Kavernenbedingungen in der Kaverne 5 einzustellen, weist das Bauteil 1 eine Öffnung 7 auf. Die Öffnung 7 wird an den ersten und/oder den zweiten Bauelementabschnitt 2b ausgebildet. Gemäß dem Ausführungsbeispiel ist die Öffnung 7 an dem zweiten Bauelementabschnitt 2b, dem Kappenbauelement, ausgebildet. Die Öffnung 7 ist als eine Druckverbindung ausgebildet. Die Öffnung 7 verbindet die Kaverne 5 mit einer Umgebung U des Bauteils 1. Durch die Öffnung 7 findet ein Druckausgleich zwischen der Umgebung U und der Kaverne 5 statt, sodass durch die Umgebung U der bestimmte Innendruck und/oder die Gasfüllung in der Kaverne 5 eingestellt wird.

Unter der Öffnung 7 ist eine beliebige Öffnung und/oder Loch zu verstehen, welches geeignet ist, die Kaverne 5 mit der Umgebung U fluidtechnisch zu verbinden. Gemäß dem Ausführungsbeispiel ist die Öffnung 7 als eine Bohrung ausgebildet. Die Öffnung 7 wird beispielsweise in den jeweiligen Bauelementabschnitt 2a, b eingebohrt. Beispielsweise weist die Öffnung 7 einen Kanal oder ein Labyrinth auf, welcher mit einem Öffnungseinlass an einer Bauelementoberfläche und einem Öffnungsauslass an der Kappenausnehmung verbunden ist.

Zur hermetischen Abdichtung der Kaverne 5 wird in einem Schritt des Verfahrens zum Verschweißen des Bauteils 1 ein Füllstück 8 an dem jeweiligen Bauelementabschnitt 2a, b mit der Öffnung 7 angeordnet. Das Füllstück ist gemäß dem Ausführungsbeispiel in seiner Grundform als ein "Stöpsel" oder "Korken" ausgebildet und an dem zweiten Bauelementabschnitt 2b angeordnet. Alternativ weist das Füllstück 8 eine andere beliebige Grundform auf, welche geeignet ist die Öffnung 7 abzudecken und/oder zu verschließen. Das Füllstück 8 wird beispielsweise in einem Applikationsschritt an dem jeweiligen Bauelementabschnitt 2a, b angeordnet. Beispielweise wird das Füllstück 8 durch einen Manipulator, z.B. einem Roboterarm, in die Öffnung 7 eingesetzt. Alternativ oder optional ergänzend wird das Füllstück 8 durch Anlegen einer weiteren Schicht (Layer), ähnlich wie bei der Wafer-Level-Ebenen Herstellung, angeordnet. Beispielsweise kann in einem nachträglichen Schritt überstehendes Material des Füllstücks 8, welches nicht zum Verschließen der Öffnung 7 benötigt wird, entfernt werden. Das Füllstück 8 wird gemäß dem Ausführungsbeispiel an dem zweiten Bauelementabschnitt 2b überstehend angeordnet. Das Füllstück 8 steht mit einem Teilabschnitt 8a aus der Öffnung 7 heraus. Der Teilabschnitt 8a weist einen überstehenden Rand auf, sodass dieser an der umliegenden Bauelementoberfläche des Bauelementabschnitts 2b anliegt.

In der Figur 2 ist in einer Detailansicht ein Ausschnitt des Bauteils 1 aus der Figur 1 gezeigt. Das Bauteil 1 weist den ersten oder den zweiten Bauelementabschnitt 2a, b auf, wobei dieser mit der Öffnung 7 ausgebildet ist. Das Bauteil 1 weist das Füllstück 8 auf, welches aus einem Füllmaterial, z.B. Silizium, hergestellt wird. Das Füllstück 8 weist in einem unverschweißten Zustand eine konusförmige Grundform auf, welche in die bohrungsartige Öffnung 7 formschlüssig eingesetzt wird. Das Füllstück 8 wird, wie zuvor beschreiben, in einem vorhergehenden Schritt des Verfahrens an dem Bauelementabschnitt 2a, b angeordnet.

Durch das Anordnen des Füllstücks 8 wird die Öffnung 7 bereits verschlossen. Um diesen "Verschluss" hermetisch abzudichten, wird in einem weiteren Schritt des Verfahrens das Füllstück 8 mit dem jeweiligen Bauelementabschnitt 2a, b durch ein Laserschweißverfahren und/oder Laserschweißen verschweißt. Das Laserschweißverfahren umfasst beispielsweise eine Laserschweißvorrichtung mit einem Laserschweißkopf 20, wobei die Laserschweißvorrichtung einen Laserstrahl L erzeugt, welcher über den Laserschweißkopf 20 zum Verschweißen austritt. In der Figur 2 ist das Laserschweißverfahren lediglich vereinfacht dargestellt, wobei der Laserstrahl L auf einen Schweißstellenbereich 9 zwischen dem Füllstück 8 und dem jeweiligen Bauelementabschnitt 2a, b ausgerichtet wird. Der Laserschweißkopf 20 ist beispielsweise beweglich ausgebildet, wobei der Laserscheißkopf 20 durch die Laserschweißvorrichtung beim Verschweißen entlang des zu verschweißenden Schweißstellenbereichs 9 bewegt wird.

Der Laserstrahl L schmilzt eine Teilmenge des Füllmaterials des Füllstück 8 sowie eine Teilmenge eines Materials des jeweiligen Bauelementabschnitts 2a, b auf, sodass eine umlaufende Schweißwulst 10 hergestellt wird. Beispielsweise wird lediglich oder vorwiegend der Teilabschnitt 8a des Füllstücks 8, welcher überstehend zu der Bauelementoberfläche angeordnet ist, aufgeschmolzen. Die Schweißwulst 10 dichtet den Schweißstellenbereich 9 ab, sodass die Öffnung 7 vollständig geschlossen wird, wodurch die im Inneren des Bauteils 1 liegende Kaverne 5 hermetisch von der Umgebung U abgedichtet wird. Bei dem Laserschweißverfahren wird eine Schweißverbindung, welche durch den Stoffschluss der Schweißwulst 10 erzeugt wird, hergestellt. Die Schweißverbindung befestigt das Füllstück 8 an dem jeweiligen Bauelementabschnitt 2a, b. Durch das beschriebene Verfahren zum Verschweißen des Bauteils 1 wird ein sehr kleines Materialvolumen des jeweiligen Bauelementabschnitts 2a, b aufgeschmolzen, da das Füllstück 8 als ein Schweißzusatz fungiert. Somit werden Beschädigungen durch Aufschmelzen des jeweiligen Bauelementabschnitts 2a, b vermieden und die thermische Belastung des Bauteils 1 reduziert.

## Patentansprüche

1. Verfahren zum Verschweißen von einem Bauteil (1) umfassend mindestens einen ersten und/oder einen zweiten Bauelementabschnitt (2a, b),
wobei, insbesondere zwischen dem ersten und dem zweiten Bauelementabschnitt (2a, b), eine Kaverne (5) ausgebildet ist,
wobei der erste und/oder der zweite Bauelementabschnitt (2a, b) eine Öffnung (7) zur Druckverbindung der Kaverne (5) mit einer Umgebung (U) des Bauteils (1) aufweist,
- bei dem ein Füllstück (8) aus einem Füllmaterial an dem jeweiligen Bauelementabschnitt (2a, b) mit der Öffnung (7) angeordnet wird, sodass die Öffnung (7) durch das Füllstück (8) zumindest abgedeckt und/oder ausgefüllt wird,
- bei dem das Füllstück (8) mit dem jeweiligen Bauelementabschnitt (2a, b) durch ein Laserschweißverfahren verschweißt wird, sodass die Öffnung (7) in dem Bauelementabschnitt (2a, b) durch das Füllmaterial des Füllstücks (8) zum hermetischen Abdichten der Kaverne (5) verschlossen wird,
wobei das Füllstück (8) das mit dem ersten oder dem zweiten Bauelementabschnitt (2a, b) verschweißt wird aus einem zu dem jeweiligen Bauelementabschnitt (2a, b) artgleichen Füllmaterial mit einer gemeinsamen Schmelztemperatur hergestellt wird,
wobei der erste Bauelementabschnitt (2a) und/oder der zweite Bauelementabschnitt (2b), und das Füllstück (8) aus Silizium oder einem siliziumhaltigen Halbleitermaterial bestehen.

2. Verfahren nach Anspruch 1, **dadurch gekennzeichnet, dass** die Kaverne (5) eine Gasfüllung aufweist, wobei die Kaverne (5) über die Öffnung (7) in einem der Bauelementabschnitte (2a, b) mit der Gasfüllung befüllt wird, wobei das Füllstück (8) mit dem jeweiligen Bauelementabschnitt (2a, b) zur gasdichten Versiegelung der Kaverne (5) verschweißt wird.

3. Verfahren nach einem der vorhergehenden Ansprüche, **dadurch gekennzeichnet, dass** die Kaverne (5) einen bestimmten Innendruck aufweist, wobei der bestimmte Innendruck in der Kaverne (5) über die Öffnung (7) in einem der Bauelementabschnitte (2a, b) angelegt wird, wobei das Füllstück (8) mit dem jeweiligen Bauelementabschnitt (2a, b) zur druckdichten Versiegelung der Kaverne (5) verschweißt wird.

4. Verfahren nach einem der vorhergehenden Ansprüche, **dadurch gekennzeichnet, dass** der erste und/oder der zweite Bauelementabschnitt (2a, b) eine Schweißverbindung zur Verbindung mit dem Füllstück (8) aufweist, wobei die Schweißverbindung durch das Laserschweißverfahren hergestellt wird.

5. Verfahren nach Anspruch 4, **dadurch gekennzeichnet, dass** in dem Laserschweißverfahren zumindest das Füllmaterial des Füllstücks (8) durch einen Laserstrahl aufgeschmolzen wird, um die Schweißverbindung zwischen dem ersten und/oder dem zweiten Bauelementabschnitt (2a, b) mit dem Füllstück (8) zu erzeugen.

6. Verfahren nach den Ansprüchen 1 bis 3, **dadurch gekennzeichnet, dass** in dem Laserschweißverfahren zumindest das Füllmaterial des Füllstücks (8) durch einen Laserstrahl vollständig aufgeschmolzen wird, um ein Schmelzbad aus zumindest dem Füllmaterial des Füllstücks (8) zum Verschließen der Öffnung (7) zu erzeugen.

7. Verfahren nach einem der vorhergehenden Ansprüche, **dadurch gekennzeichnet, dass** das Bauteil (1) ein mikroelektromechanisches System-Bauteil (MEMS-Bauteil) bildet, wobei der erste und/oder der zweite Bauelementabschnitt (2a, b) eine mikroelektromechanische Struktur (6) aufweist, wobei die mikroelektromechanische Struktur (6) innerhalb der Kaverne (5) angeordnet wird, wobei das Füllstück (8) mit dem jeweiligen Bauelementabschnitt (2a, b) zur hermetischen Abdichtung der mikroelektromechanischen Struktur (6) innerhalb der Kaverne (5) verschweißt wird.

## Claims

1. Method for welding a component (1) comprising at least one first and/or one second component portion (2a, b), wherein a cavity (5) is formed in particular between the first and the second component portion (2a, b),
wherein the first and/or the second component portion (2a, b) has an opening (7) for connecting the cavity (5) to a surrounding area (U) of the component (1) in pressure terms,
- in which method a filling piece (8) of a filling material is arranged on the respective component portion (2a, b) that has the opening (7), so that the opening (7) is at least covered and/or filled by the filling piece (8),
- in which method the filling piece (8) is welded to the respective component portion (2a, b) by a laser welding process, so that the opening (7) in the component portion (2a, b) is closed by the filling material of the filling piece (8) to hermetically seal the cavity (5),
wherein the filling piece (8) that is welded to the first or the second component portion (2a, b) is made from a filling material which is of the same type as the respective component portion (2a, b) and has a common melting temperature,
wherein the first component portion (2a) and/or the second component portion (2b), and the filling piece (8) consist of silicon or a silicon-containing semiconductor material.

2. Method according to Claim 1, **characterized in that** the cavity (5) is filled with gas, the cavity (5) being filled with the gas via the opening (7) in one of the component portions (2a, b), wherein the filling piece (8) is welded to the respective component portion (2a, b) to gas-tightly seal the cavity (5).

3. Method according to either of the preceding claims, **characterized in that** the cavity (5) has a determined internal pressure, the internal pressure in the cavity (5) being applied via the opening (7) in one of the component portions (2a, b), wherein the filling piece (8) is welded to the respective component portion (2a, b) to pressure-tightly seal the cavity (5).

4. Method according to any of the preceding claims, **characterized in that** the first and/or the second component portion (2a, b) has a welded connection for connection to the filling piece (8), the welded connection being established by the laser welding process.

5. Method according to Claim 4, **characterized in that** the laser welding process involves using a laser beam to melt at least the filling material of the filling piece (8), in order to establish the welded connection between the first and/or the second component portion (2a, b) and the filling piece (8).

6. Method according to Claims 1 to 3, **characterized in that** the laser welding process involves using a laser beam to completely melt at least the filling material of the filling piece (8), in order to create a melt pool from at least the filling material of the filling piece (8) to close the opening (7).

7. Method according to any of the preceding claims, **characterized in that** the component (1) forms a microelectromechanical system component (MEMS component), wherein the first and/or the second component portion (2a, b) has a microelectromechanical structure (6), wherein the microelectromechanical structure (6) is arranged within the cavity (5), wherein the filling piece (8) is welded to the respective component portion (2a, b) to hermetically seal the microelectromechanical structure (6) inside the cavity (5).

## Revendications

1. Procédé de soudage d'un composant (1) comprenant au moins une première et/ou une seconde section (2a, b) de composant, une cavité (5) étant formée en particulier entre la première et la seconde section (2a, b) de composant,
la première et/ou la seconde section (2a, b) de composant comportant une ouverture (7) destinée à relier sous pression la cavité (5) à un environnement (U) du composant (1),
- dans lequel une pièce de remplissage (8) en un matériau de remplissage est disposée sur la section (2a, b) de composant respective avec l'ouverture (7) si bien que l'ouverture (7) est au moins recouverte et/ou remplie par la pièce de remplissage (8),
- dans lequel la pièce de remplissage (8) est soudée à la section (2a, b) de composant respective par un procédé de soudage au laser si bien que l'ouverture (7) dans la section (2a, b) de composant est fermée par le matériau de remplissage de la pièce de remplissage (8) pour étanchéifier hermétiquement la cavité (5),
la pièce de remplissage (8), qui est soudée à la première ou la seconde section (2a, b) de composant, étant fabriquée à partir d'un matériau de remplissage similaire par rapport à la section (2a, b) de composant respective avec une température de fusion commune,
la première section (2a) de composant et/ou la seconde section (2b) de composant et la pièce de remplissage (8) étant constituées de silicium ou d'un matériau semi-conducteur contenant du silicium.

2. Procédé selon la revendication 1, **caractérisé en ce que** la cavité (5) comporte un remplissage de gaz, la cavité (5) étant remplie du remplissage de gaz par l'ouverture (7) dans une des sections (2a, b) de composant, la pièce de remplissage (8) étant soudée à la section (2a, b) de composant respective pour le scellement étanche aux gaz de la cavité (5).

3. Procédé selon l'une des revendications précédentes, **caractérisé en ce que** la cavité (5) présente une pression intérieure définie, la pression intérieure définie dans la cavité (5) étant appliquée par l'ouverture (7) dans une des sections (2a, b) de composant, la pièce de remplissage (8) étant soudée à la section (2a, b) de composant respective pour le scellement étanche à la pression de la cavité (5).

4. Procédé selon l'une des revendications précédentes, **caractérisé en ce que** la première et/ou la seconde section (2a, b) de composant présentent une liaison par soudage pour la liaison à la pièce de remplissage (8), la liaison par soudage étant réalisée par le procédé de soudage au laser.

5. Procédé selon la revendication 4, **caractérisé en ce qu'**au moins le matériau de remplissage de la pièce de remplissage (8) est fondu par un rayon laser dans le procédé de soudage au laser pour générer la liaison par soudage entre la première et/ou la seconde section (2a, b) de composant avec la pièce de remplissage (8).

6. Procédé selon les revendications 1 à 3, **caractérisé en ce qu'**au moins le matériau de remplissage de la pièce de remplissage (8) est totalement fondu par un rayon laser dans le procédé de soudage au laser pour générer un bain de fusion à partir d'au moins le matériau de remplissage de la pièce de remplissage (8) pour souder l'ouverture (7).

7. Procédé selon l'une des revendications précédentes, **caractérisé en ce que** le composant (1) constitue un composant de microsystème électromécanique (composant MEMS), la première et/ou la seconde section (2a, b) de composant comportant une microstructure électromécanique (6), la microstructure électromécanique (6) étant disposée à l'intérieur de la cavité (5), la pièce de remplissage (8) étant soudée à la section (2a, b) de composant respective pour l'étanchéification hermétique de la microstructure électromécanique (6) à l'intérieur de la cavité (5).
